# EUROPÄISCHE PATENTSCHRIFT

(11) **EP 2 341 624 B1**
(45) Veröffentlichungstag und Bekanntmachung des Hinweises auf die Patenterteilung: **21.10.2015**
(21) Anmeldenummer: 10015603.3
(22) Anmeldetag: 14.12.2010
(51) Int. Cl.: H03K 17/96

(54) **Kapazitiver Berührungsschalter**
Capacitive contact switch
Interrupteur à contact capacitif

(30) Priorität: 23.12.2009 DE 102009060210
(43) Veröffentlichungstag der Anmeldung: 06.07.2011
(73) Patentinhaber: Diehl AKO Stiftung & Co. KG, 88239 Wangen (DE)
(72) Erfinder: Siebachmeyer, Fritz, 88099 Neukirch (DE)
(74) Vertreter: Diehl Patentabteilung

(56) Entgegenhaltungen:
- EP-A1- 2 048 781
- WO-A1-2006/034993
- WO-A1-2008/022866
- WO-A1-2010/035936
- DE-A1-102005 041 111
- DE-A1-102005 053 792
- FR-A1- 2 704 332

## Beschreibung

Die vorliegende Erfindung betrifft einen kapazitiven Berührungsschalter.

In vielen elektrischen bzw. elektronischen Geräten, insbesondere auch in Haushaltsgeräten wie Herden, Kochfeldern, Mikrowellenöfen, Spülmaschinen, Waschmaschinen, Wäschetrocknern und dergleichen, werden häufig berührungsempfindliche Tastschalter bzw. Berührungsschalter eingesetzt, die durch ein einfaches Berühren oder Annähern durch einen Benutzer zum Beispiel einen bestimmten Schaltvorgang auslösen und/oder eine Geräteeinstellung ändern.

Im Fall eines kapazitiven Berührungsschalters bildet ein kapazitives Sensorelement zusammen mit zum Beispiel einem Finger eines Benutzers über eine als Dielektrikum wirkende Abdeckung eine Kapazität, die entsprechend dem Betätigen des Tastschalters, d.h. dem Berühren oder Nicht-Berühren eines dem kapazitiven Sensorelement zugeordneten Berührungsfeldes der Abdeckung variabel ist. Die Veränderung des Kapazitätswertes des kapazitiven Sensorelements wirkt sich entsprechend auf ein Ausgangssignal der Sensorschaltung aus, was von der Auswerteelektronik als eine Betätigung des kapazitiven Berührungsschalters interpretiert werden kann.

Derartige kapazitive Berührungsschalter sind zum Beispiel aus der DE 10 2005 053 792 A1 bekannt. Das kapazitive Sensorelement dieser bekannten Berührungsschalter ist durch eine Druckfeder aus einem elektrisch leitenden Material und ein Kontaktelement aus einem elektrisch leitenden Material, das auf der der Abdeckplatte zugewandten Seite der Druckfeder angeordnet und mit der Druckfeder elektrisch leitend in Kontakt ist, gebildet. Zur positionsgenauen Montage des Sensorelements ist in einer Variante innerhalb der Druckfeder ein Haltestift angeordnet, der in eine entsprechende Durchbrechung in der Leiterplatte geklemmt werden kann. Einen weiteren kapazitiven Berührungsschalter mit einem Sensorelement mit Druckfeder und Kontaktelement(en) sowie einem zentralen Haltestift zeigt die FR 2,704,332 A1.

Die WO 2006/034993 A1 offenbart einen kapazitiven Berührungsschalter mit einer Druckfeder aus einem elektrisch leitfähigen Material, die zwischen einer elektrisch isolierenden Abdeckplatte und einer im Abstand zu dieser angeordneten Trägerplatte angeordnet ist. Die Windung der Druckfeder an dem der Trägerplatte zugewandte Ende ist mit einer angeformten Lötöse ausgebildet, die durch ein Loch in der Trägerplatte hindurch ragt und mit der Trägerplatte verlötet werden kann.

Der Erfindung liegt die Aufgabe zugrunde, einen kapazitiven Berührungsschalter mit positionsgenauer Montierbarkeit zu schaffen.

Diese Aufgabe wird gelöst durch einen kapazitiven Berührungsschalter mit den Merkmalen des Anspruches 1. Vorteilhafte Ausgestaltungen und Weiterbildungen der Erfindung sind Gegenstand der abhängigen Ansprüche.

Der kapazitive Berührungsschalter weist ein kapazitives Sensorelement auf, das aus einem elektrisch leitfähigen Hohlkörper in Form einer Spiralfeder besteht, die sich von einer Trägerplatte in Richtung zu einer im Abstand zu dieser angeordneten elektrisch isolierenden Abdeckplatte erstreckt. Zusätzlich ist ein Führungskörper aus einem elektrisch isolierenden Material vorgesehen, der sich ausgehend von der Abdeckplatte in den Hohlkörper hinein erstreckt. Auf der Abdeckplatte ist ein Berührungsfeld vorgesehen und der Führungskörper legt die Position des Hohlkörpers relativ zu diesem Berührungsfeld fest.

Erfindungsgemäß erstreckt sich ein Führungskörper aus einem elektrisch isolierenden Material ausgehend von der Abdeckplatte in den Hohlkörper hinein. Der Führungskörper, der natürlich im Bereich des entsprechenden Berührungsfeldes der Abdeckplatte vorgesehen ist, legt so die Position des elektrisch leitfähigen Hohlkörpers relativ zu diesem Berührungsfeld fest. Auf diese Weise kann eine positionsgenaue Montage des kapazitiven Sensorelements gewährleistet werden. Dabei kann der Führungskörper zudem den Montagevorgang vereinfachen, da zusätzliche Positionierungshilfen entfallen können.

Der elektrisch leitfähige Hohlkörper bildet das kapazitive Sensorelement, welches zusammen mit zum Beispiel einem Finger eines Benutzers über die als Dielektrikum wirkende Abdeckplatte eine Kapazität bildet, die entsprechend dem Berühren oder Nicht-Berühren eines dem kapazitiven Sensorelement zugeordneten Berührungsfeldes der Abdeckplatte variabel ist.

Der sich in das kapazitive Sensorelement hinein erstreckende Führungskörper kann zudem die Kopplungskapazität erhöhen und dadurch wiederum die Sensitivität des kapazitiven Berührungsschalters verbessern. Als Kopplungsfläche des Sensorelements dient einerseits die der Abdeckplatte zugewandte Stirnfläche und bei der erfindungsgemäßen Konstruktion des kapazitiven Berührungsschalters zudem die dem Führungskörper angrenzende Innenfläche des Hohlkörpers. Das Dielektrikum wird daher nicht nur durch die Abdeckplatte, sondern zusätzlich durch das Material des Führungskörpers gebildet.

Die Trägerplatte kann zum Beispiel eine Leiterplatte oder eine Kunststoffplatte sein. Die Trägerplatte kann außerdem als stabiler Plattenkörper ausgebildet sein oder nur Folienstärke aufweisen.

Der Hohlkörper hat eine grundsätzlich beliebige Querschnittsform (z.B. Kreis, Ellipse, Rechteck, etc.). Außerdem kann seine Innenquerschnittsform wahlweise gleich oder unterschiedlich zu seiner Außenquerschnittsform ausgebildet sein. Ferner kann die Querschnittsform wahlweise die Form eines geschlossenen oder offenen Ringes haben, d.h. ohne oder mit Unterbrechungen entlang des Umfanges gebildet sein.

Gemäß der Erfindung ist der Hohlkörper als eine Spiralfeder ausgebildet. Vorzugsweise handelt es sich bei der Spiralfeder um eine Druckfeder zur besseren bzw. sichereren Kontaktierung der Trägerplatte und der Abdeckplatte bzw. einer Erweiterung des Führungskörpers durch das kapazitive Sensorelement.

In einer Ausgestaltung der Erfindung ist der Führungskörper integral mit der Abdeckplatte ausgebildet. Beispielsweise ist der Führungskörper an der der Trägerplatte zugewandten Seite der Abdeckplatte angeformt. In diesem Fall ist der Führungskörper aus dem gleichen Material wie die Abdeckplatte gebildet.

In einer anderen Ausgestaltung der Erfindung ist der Führungskörper mit der der Trägerplatte zugewandten Seite der Abdeckplatte verbunden. Der Führungskörper ist beispielsweise mit der Abdeckplatte verklebt oder an diese angegossen. In diesem Fall kann der Führungskörper aus einem anderen Material als die Abdeckplatte gebildet sein.

In einer noch weiteren Ausgestaltung der Erfindung erstreckt sich der Führungskörper durch eine Durchbrechung in der Abdeckplatte hindurch. Auch in diesem Fall kann der Führungskörper aus einem anderen Material als die Abdeckplatte gebildet sein.

Bei den beiden letztgenannten Ausgestaltungen besteht ferner die Möglichkeit, dass der Führungskörper eine Erweiterung aufweist, deren Durchmesser größer als jener des Hohlkörpers ist und die zwischen den Hohlkörper und die Abdeckplatte eingesetzt ist.

Vorzugsweise beträgt die Dielektrizitätskonstante bzw. relative Permittivität des Führungskörpers wenigstens etwa 2,0. D.h. die Dielektrizitätskonstante des Führungskörpers ist deutlich größer als jene von Luft, die sich bei den herkömmlichen Anordnungen im Innern des Hohlkörper-Sensorelements befindet. Hierdurch können die Kopplungskapazität für das kapazitive Sensorelement deutlich erhöht und damit die Sensitivität des Schalters verbessert werden.

In einer bevorzugten Ausgestaltung kann auf der Trägerplatte innerhalb des Hohlkörpers zudem wenigstens eine Lichtquelle angeordnet sein. Der Führungskörper - und je nach Ausführungsform auch die Abdeckplatte - ist dann zumindest teilweise lichtdurchlässig ausgebildet. Bei dieser Ausgestaltung besteht die Möglichkeit, das dem kapazitiven Sensorelement zugeordnete Berührungsfeld auf der Abdeckplatte zu hinterleuchten bzw. zu kennzeichnen und/oder einen Schaltzustand des kapazitiven Berührungsschalters zu signalisieren.

Gemäß der Erfindung ist der Führungskörper in Richtung zur Trägerplatte zumindest teilweise sich konisch verjüngend ausgebildet. Hierdurch kann die Montage des kapazitiven Sensorelements in Bezug auf die Abdeckplatte vereinfacht werden.

Gemäß der Erfindung ist der Hohlkörper zumindest in seinem der Abdeckplatte zugewandten Endbereich in Richtung zur Abdeckplatte zumindest teilweise sich konisch erweiternd ausgebildet. Auch durch diese Maßnahme kann die Montage des kapazitiven Sensorelements in Bezug auf die Abdeckplatte vereinfacht werden.

Obige sowie weitere Merkmale, Vorteile und Anwendungsmöglichkeiten der Erfindung werden aus der nachfolgenden Beschreibung bevorzugter, nicht-einschränkender Ausführungsbeispiele unter Bezugnahme auf die beiliegenden Zeichnungen besser verständlich. Darin zeigen:
- Fig.1 1: eine schematische Querschnittsansicht eines kapazitiven Berührungsschalters gemäß einem ersten Ausführungsbeispiel der vorliegenden Erfindung;
- Fig. 2: eine schematische Querschnittsansicht eines kapazitiven Berührungsschalters gemäß einem zweiten Ausführungsbeispiel der vorliegenden Erfindung;
- Fig.3: eine schematische Querschnittsansicht eines kapazitiven Berührungsschalters gemäß einem dritten Ausführungsbeispiel der vorliegenden Erfindung; und
- Fig.4: eine schematische Querschnittsansicht eines kapazitiven Berührungsschalters gemäß einem vierten Ausführungsbeispiel der vorliegenden Erfindung.

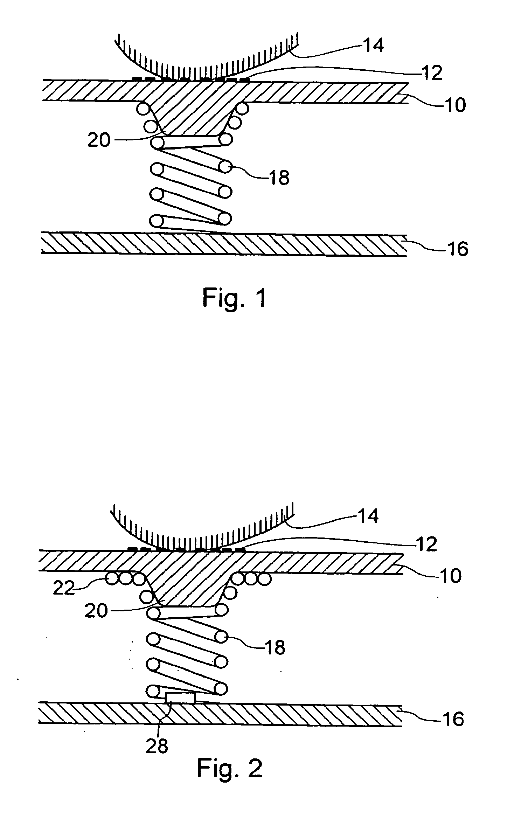

Bezug nehmend auf Fig. 1 wird nun ein erstes Ausführungsbeispiel eines kapazitiven Berührungsschalters näher erläutert.

Hinter einer Abdeckplatte 10, die zum Beispiel Teil einer Bedienblende eines Haushaltsgeräts ist oder in eine solche integriert ist, ist ein kapazitives Sensorelement angeordnet. Die Abdeckplatte 10 ist aus einem elektrisch isolierenden Material wie zum Beispiel aus Glas, Glaskeramik oder Kunststoff gefertigt, sodass sie in bekannter. Weise als ein Dielektrikum des kapazitiven Berührungsschalters dienen kann.

Auf der dem Benutzer zugewandten Seite der Abdeckplatte 10 (oben in Fig. 1) ist ein Berührungsfeld 12 vorgesehen, welches von einem Benutzer mit dem Finger 14 berührt werden kann. Dieses Berührungsfeld 12 ist vorzugsweise in irgendeiner Weise gekennzeichnet, um die Bedienung für den Benutzer zu vereinfachen.

Auf der dem Benutzer abgewandten Seite der Abdeckplatte 10 (unten in Fig. 1) ist mit einem Abstand zu dieser eine Leiterplatte 16 angeordnet. Diese Leiterplatte 16 trägt die Sensorschaltung und die Auswerteelektronik. Außerdem kann sie Teil der Steuerung des Haushaltsgeräts sein oder mit dieser über entsprechende Kabelverbindungen verbunden sein.

Zum Ausbilden des kapazitiven Sensorelements ist zwischen der Abdeckplatte 10 und dieser Leiterplatte 16 ein elektrisch leitfähiger Hohlkörper 18 in Form einer Spiralfeder, insbesondere einer Druckfeder angeordnet. Die letzte Windung dieser Druckfeder 18 an ihrem der Abdeckplatte 10 zugewandten Ende bildet die Sensorfläche des kapazitiven Berührungsschalters und definiert Form und Größe des Berührungsfeldes 12 auf der Abdeckplatte 10. Andererseits ist die letzte Windung der Druckfeder 18 an ihrem der Leiterplatte 16 zugewandten Ende (unten in Fig. 1) mit einer entsprechenden elektrisch leitenden Kontaktfläche auf der Leiterplatte 16 verbunden.

Wie in Fig. 1 dargestellt, ist an der der Leiterplatte 16 zugewandten Seite der Abdeckplatte 10 im Bereich des Berührungsfeldes 12 an der Abdeckplatte 10 ein Führungskörper 20 angeformt, d.h. integral mit der Abdeckplatte ausgebildet. Dieser Führungskörper 20 aus elektrisch isolierendem Material erstreckt sich in Richtung zur Leiterplatte 16 in die Druckfeder 18 hinein und legt damit die Position der Druckfeder 18 in Bezug auf die Abdeckplatte 10 und das Berührungsfeld 12 fest. Die Dielektrizitätskonstante des Führungskörpers 20 ist mit einem Wert von wenigstens etwa 2,0 wesentlich größer als jene von Luft (z.B. Faktor 2,5 bis 3,0).

Um die Montage der als kapazitives Sensorelement dienenden Druckfeder 18 zu vereinfachen, sind der Führungskörper 20 sich in Richtung zur Leiterplatte 16 konisch verjüngend und die Druckfeder 18 an ihrem der Abdeckplatte 10 zugewandten Endbereich sich erweiternd ausgebildet.

Der sich innerhalb der Druckfeder 18 befindende Führungskörper 20 dient einerseits der Positionierung der Druckfeder 18 in Bezug zur Abdeckplatte 10 und vergrößert andererseits das Dielektrikum und damit die Kopplungskapazität, das bzw. die zwischen der elektrisch leitfähigen Druckfeder 18 und dem Finger 14 eines Benutzers ausgebildet ist. Hierdurch ist die Sensitivität des kapazitiven Berührungsschalters erhöht.

Bezug nehmend auf Fig. 2 wird nun ein zweites Ausführungsbeispiel eines kapazitiven Berührungsschalters näher erläutert. Dabei sind gleiche bzw. ähnliche Komponenten mit den gleichen Bezugsziffern wie im ersten Ausführungsbeispiel gekennzeichnet.

Im Vergleich zum Ausführungsbeispiel von Fig. 1 weist die Druckfeder 18 in diesem Ausführungsbeispiel an ihrem der Abdeckplatte 10 zugewandten Ende (oben in Fig. 2) mehrere spiralförmig ineinander verlaufende Windungen 22 auf. Diese Windungen 22 vergrößern die Sensorfläche des kapazitiven Sensorelements und verbessern damit die Sensitivität des kapazitiven Berührungsschalters.

Außerdem ist auf der Leiterplatte 16 innerhalb der Druckfeder 18 wenigstens eine Lichtquelle 28, zum Beispiel eine Leuchtdiode, angeordnet. Der Führungskörper 20 und der Bereich der Abdeckplatte 10, der dem Berührungsfeld 12 des kapazitiven Berührungsschalters entspricht, sind zumindest teilweise lichtdurchlässig ausgebildet. Auf diese Weise kann das Berührungsfeld 12 der Abdeckplatte 10 für den Benutzer hinterleuchtet und damit gekennzeichnet werden. Außerdem besteht die Möglichkeit, den Schaltzustand des Berührungsschalters zu signalisieren, zum Beispiel anhand der Farbe der Lichtquelle 28 oder des Einschaltzustandes (ein, aus, blinkend) der Lichtquelle 28.

Es besteht natürlich auch die Möglichkeit, auf die wenigstens eine Lichtquelle 28 oder die Spiralwindungen 22 zu verzichten.

Die übrigen Merkmale des kapazitiven Berührungsschalters entsprechen jenen des Ausführungsbeispiels von Fig. 1.

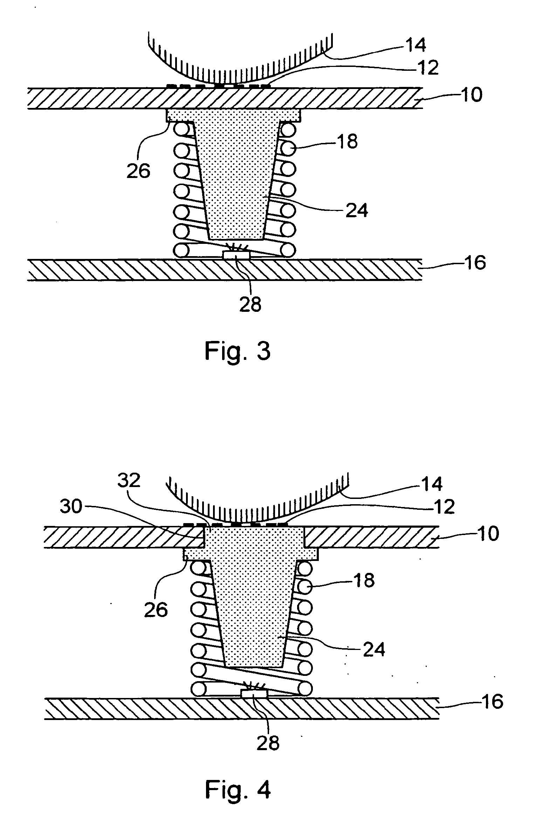

Bezug nehmend auf Fig. 3 wird nun ein drittes Ausführungsbeispiel eines kapazitiven Berührungsschalters beschrieben. Dabei sind gleiche bzw. ähnliche Komponenten mit den gleichen Bezugsziffern wie in den Ausführungsbeispielen von Fig. 1 und 2 gekennzeichnet.

Der Führungskörper 24 ist aus einem anderen Material als die Abdeckplatte 10 gefertigt. Insbesondere ist der Führungskörper 24 als ein Lichtleitelement ausgebildet.

Der Führungskörper 24 aus elektrisch isolierendem Material ist mit seinem der Abdeckplatte 10 zugewandten Ende mit dieser verbunden, zum Beispiel verklebt. Hierdurch kann ein positionsgenauer Bezug zwischen dem Führungskörper 24 und dem Berührungsfeld 12 auf der Abdeckplatte 10 erzielt werden, was wiederum eine positionsgenaue Montage des kapazitiven Sensorelements in Form der Druckfeder 18 gewährleistet.

Das Lichtleitelement 24 ragt im Gegensatz zu dem an der Abdeckplatte 10 angeformten Führungskörper 20 der Ausführungsbeispiele von Fig. 1 und 2 bis nahe zur Leiterplatte 16 in die Druckfeder 18 hinein. Auf der Leiterplatte 16 ist innerhalb der Druckfeder 18 wenigstens eine Lichtquelle 28, zum Beispiel eine Leuchtdiode, angeordnet, deren ausgesendete Strahlung in das Lichtleitelement einkoppelt.

Die Abdeckplatte 10 ist im Bereich des Berührungsfeldes 12 zumindest teilweise lichtdurchlässig ausgebildet, sodass die Strahlung der Lichtquelle 28 durch das Lichtleitelement 24 in die Abdeckplatte 10 einkoppeln kann und im Bereich des Berührungsfeldes 12 für den Benutzer sichtbar ist.

Wie in Fig. 3 dargestellt, weist das Lichtleitelement 24 an seinem der Abdeckplatte 10 zugewandten Ende vorzugsweise eine Erweiterung 26 auf. Diese Erweiterung 26 ist größer bemessen als der Querschnitt der Druckfeder 18, sodass die Erweiterung 26 des Lichtleitelements 24 zwischen die als Sensorfläche dienende letzte Windung der Druckfeder 18 und die Abdeckplatte 10 gesetzt ist.

Die Erweiterung 26 des Lichtleitelements 24 ermöglicht einerseits eine stabilere Positionierung der Druckfeder 18 und andererseits eine größere Ausleuchtung des Berührungsfeldes 12 auf der Abdeckplatte 10.

Um die Montage der als kapazitives Sensorelement dienenden Druckfeder 18 zu vereinfachen, sind bei dieser Ausführungsform vorzugsweise das Lichtleitelement 24 sich in Richtung zur Leiterplatte 16 konisch verjüngend und die Druckfeder 18 an ihrem der Abdeckplatte 10 zugewandten Endbereich sich erweiternd ausgebildet.

Die übrigen Merkmale des kapazitiven Berührungsschalters entsprechen jenen des ersten Ausführungsbeispiels von Fig. 1.

Bezug nehmend auf Fig. 4 wird nun ein viertes Ausführungsbeispiel eines kapazitiven Berührungsschalters erläutert. Dabei sind gleiche bzw. ähnliche Komponenten mit den gleichen Bezugsziffern wie in dem dritten Ausführungsbeispiel von Fig. 3 gekennzeichnet.

Im Vergleich zum Ausführungsbeispiel von Fig. 3 ist die Abdeckplatte 10 bei dieser Ausführungsform nicht durchgehend ausgebildet, sondern weist im Bereich des Berührungsfeldes 12 eine Durchbrechung 30 auf.

Durch diese Durchbrechung 30 in der Abdeckplatte 10 ragt ein Vorsprung 32 des Lichtleitelements 24 hindurch. Die Stirnfläche des Vorsprungs 32 schließt dabei bevorzugt bündig mit der Oberseite der Abdeckplatte 10 ab.

Aufgrund des Einsetzens des Lichtleitelements 24 in die Durchbrechung 30 der Abdeckplatte 10 ist die Positionierung des gleichzeitig als Führungskörper dienenden Lichtleitelements 24 in Bezug auf das Berührungsfeld 12 der Abdeckplatte 10 einfacher als zum Beispiel bei der Ausführungsform von Fig. 3. Hierdurch ist wiederum auch die Positionsgenauigkeit des als kapazitives Sensorelement dienenden Hohlkörpers 18 in Bezug auf die Abdeckplatte 10 und ihr Berührungsfeld 12 verbessert.

Die übrigen Merkmale dieses kapazitiven Berührungsschalters entsprechen jenen des dritten Ausführungsbeispiels von Fig. 3.

Analog zum Ausführungsbeispiel von Fig. 2 können auch bei den beiden Ausführungsbeispielen von Fig. 3 und 4 jeweils die Druckfedern 18 an ihrem der Abdeckplatte 10 bzw. der Erweiterung 26 des Lichtleitelements 24 zugewandten Ende mit spiralförmig ineinander verlaufenden Windungen 22 ausgebildet sein, um die Sensorfläche zu vergrößern.

Ferner müssen die Führungskörper 24 des dritten und vierten Ausführungsbeispiels nicht notwendigerweise als Lichtleitelemente ausgebildet sein. Bei dieser Konstruktion der Führungskörper 24 können sie allgemein aus einem anderen, elektrisch isolierenden Material als die Abdeckplatte 10 gebildet sein.

Während in den oben beschriebenen Ausführungsbeispielen als Trägerplatte 16 jeweils eine Leiterplatte verwendet wird, ist die Erfindung nicht nur auf diese Ausführungsformen beschränkt. So kann als Trägerplatte 16 zum Beispiel auch ein Kunststoffteil verwendet werden.

### BEZUGSZIFFERNLISTE

- 10: Abdeckplatte
- 12: Berührungsfeld
- 14: Finger eines Benutzers
- 16: Trägerplatte
- 18: Hohlkörper
- 20: Führungskörper
- 22: Windungen
- 24: Führungskörper
- 26: Erweiterung
- 28: Lichtquelle
- 30: Durchbrechung
- 32: Vorsprung

## Patentansprüche

1. Kapazitiver Berührungsschalter, mit einem kapazitiven Sensorelement, das aus einem elektrisch leitfähigen Hohlkörper (18) in Form einer Spiralfeder besteht, die sich von einer Trägerplatte (16) in Richtung zu einer im Abstand zu dieser angeordneten elektrisch isolierenden Abdeckplatte (10) erstreckt, auf welcher ein Berührungsfeld vorgesehen ist, und deren letzte Windung an ihrem der Abdeckplatte (10) zugewandten Ende eine Sensorfläche des kapazitiven Berührungsschalters bildet und Form und Größe des Berührungsfeldes (12) auf der Abdeckplatte (10) definiert,
**dadurch gekennzeichnet,**
**dass** ein Führungskörper (20, 24) aus einem elektrisch isolierenden Material vorgesehen ist, der sich ausgehend von der Abdeckplatte (10) in den Hohlkörper (18) hinein erstreckt und die Position des Hohlkörpers (18) relativ zu dem Berührungsfeld (12) festlegt, wobei der Führungskörper (20, 24) in Richtung zur Trägerplatte (16) zumindest teilweise sich konisch verjüngend ausgebildet ist und der Hohlkörper (18) zumindest in seinem der Abdeckplatte (10) zugewandten Endbereich in Richtung zur Abdeckplatte (10) zumindest teilweise sich konisch erweiternd ausgebildet ist.

2. Kapazitiver Berührungsschalter nach Anspruch 1,
**dadurch gekennzeichnet,**
**dass** der Führungskörper (20) integral mit der Abdeckplatte (10) ausgebildet ist.

3. Kapazitiver Berührungsschalter nach Anspruch 1,
**dadurch gekennzeichnet,**
**dass** der Führungskörper (24) mit der der Trägerplatte (16) zugewandten Seite der Abdeckplatte (10) verbunden ist.

4. Kapazitiver Berührungsschalter nach Anspruch 1 oder 3,
**dadurch gekennzeichnet,**
**dass** sich der Führungskörper (24) durch eine Durchbrechung (30) in der Abdeckplatte (10) hindurch erstreckt.

5. Kapazitiver Berührungsschalter nach Anspruch 3 oder 4,
**dadurch gekennzeichnet,**
**dass** der Führungskörper (24) eine Erweiterung (26) aufweist, deren Durchmesser größer als jener des Hohlkörpers (18) ist und die zwischen den Hohlkörper (18) und die Abdeckplatte (10) eingesetzt ist.

6. Kapazitiver Berührungsschalter nach einem der vorherigen Ansprüche,
**dadurch gekennzeichnet,**
**dass** eine Dielektrizitätskonstante des Führungskörpers (20, 24) wenigstens etwa 2,0 beträgt.

7. Kapazitiver Berührungsschalter nach einem der vorherigen Ansprüche,
**dadurch gekennzeichnet,**
**dass** auf der Trägerplatte (16) innerhalb des Hohlkörpers (18) wenigstens eine Lichtquelle (28) angeordnet ist; und
**dass** der Führungskörper (24) zumindest teilweise lichtdurchlässig ausgebildet ist.

## Claims

1. Capacitive touch switch, having a capacitive sensor element which comprises an electrically conductive hollow body (18) in the form of a helical spring which extends from a support plate (16) in the direction of an electrically insulating cover plate (10) which is arranged at a distance from said support plate and on which a touch area is provided, and of which helical spring the last turn forms, at its end which faces the cover plate (10), a sensor area of the capacitive touch switch and defines the shape and size of the touch area (12) on the cover plate (10), **characterized in that** a guide body (20, 24) which is composed of an electrically insulating material is provided, the said guide body extending from the cover plate (10) into the hollow body (18) and defining the position of the hollow body (18) relative to the touch area (12), wherein the guide body (20, 24) is of at least partially conically tapering design in the direction of the support plate (16), and the hollow body (18) is of at least partially conically widening design at least in its end region, which faces the cover plate (10), in the direction of the cover plate (10).

2. Capacitive touch switch according to Claim 1, **characterized in that** the guide body (20) is integrally formed with the cover plate (10).

3. Capacitive touch switch according to Claim 1, **characterized in that** the guide body (24) is connected to that side of the cover plate (10) which faces the support plate (16).

4. Capacitive touch switch according to Claim 1 or 3, **characterized in that** the guide body (24) extends through an aperture (30) in the cover plate (10).

5. Capacitive touch switch according to Claim 3 or 4, **characterized in that** the guide body (24) has a widened portion (26), the diameter of the said widened portion being greater than that of the hollow body (18), and the said widened portion being inserted between the hollow body (18) and the cover plate (10).

6. Capacitive touch switch according to one of the preceding claims, **characterized in that** a dielectric constant of the guide body (20, 24) is at least approximately 2.0.

7. Capacitive touch switch according to one of the preceding claims, **characterized in that** at least one light source (28) is arranged on the support plate (16) within the hollow body (18); and **in that** the guide body (24) is at least partially permeable to light.

## Revendications

1. Commutateur tactile capacitif, muni d'un élément de détection capacitif qui se compose d'un corps creux (18) électriquement conducteur sous la forme d'un ressort en spirale, lequel s'étend d'une plaque porteuse (16) en direction d'une plaque de protection (10) électriquement isolante espacée de celle-ci, sur laquelle se trouve un champ tactile, et dont la dernière spire à son extrémité faisant face à la plaque de protection (10) forme une surface de détection du commutateur tactile capacitif et définit la forme ainsi que la taille du champ tactile (12) sur la plaque de protection (10),
**caractérisé en ce**
**qu'**il existe un corps de guidage (20, 24) en un matériau électriquement isolant qui s'étend depuis la plaque de protection (10) vers l'intérieur du corps creux (18) et qui définit la position du corps creux (18) par rapport au champ tactile (12), le corps de guidage (20, 24) étant configuré avec un rétrécissement conique au moins partiel en direction de la plaque porteuse (16) et le corps creux (18) étant configuré avec un élargissement conique au moins partiel en direction de la plaque de protection (10) au moins dans sa zone d'extrémité qui fait face à la plaque de protection (10).

2. Commutateur tactile capacitif selon la revendication 1, **caractérisé en ce que** le corps de guidage (20) est réalisé d'une seule pièce avec la plaque de protection (10).

3. Commutateur tactile capacitif selon la revendication 1, **caractérisé en ce que** le corps de guidage (24) est relié au côté de la plaque de protection (10) qui fait face à la plaque porteuse (16).

4. Commutateur tactile capacitif selon la revendication 1 ou 3, **caractérisé en ce que** le corps de guidage (24) s'étend à travers une percée (30) dans la plaque de protection (10).

5. Commutateur tactile capacitif selon la revendication 3 ou 4, **caractérisé en ce que** le corps de guidage (24) possède un élargissement (26) dont le diamètre est supérieur à celui du corps creux (18) et qui est inséré entre le corps creux (18) et la plaque de protection (10).

6. Commutateur tactile capacitif selon l'une des revendications précédentes, **caractérisé en ce qu'**une constante diélectrique du corps de guidage (20, 24) est au moins égale à environ 2,0.

7. Commutateur tactile capacitif selon l'une des revendications précédentes, **caractérisé en ce qu'**au moins une source de lumière (28) est disposée sur la plaque porteuse (16) à l'intérieur du corps creux (18) ; et **en ce que** le corps de guidage (24) est réalisé au moins partiellement transparent.
